# EUROPEAN PATENT APPLICATION

(11) **EP 4 712 125 A1**
(43) Date of publication of application: **18.03.2026**
(21) Application number: 25193421.2
(22) Date of filing: 01.08.2025
(51) Int. Cl.: H01J 37/26, H01J 37/28

(54) **MAGNETIC MAGNIFICATION CONTROL FOR TRANSMISSION ELECTRON MICROSCOPES**

(30) Priority: 11.09.2024 US 202418882123
(71) Applicant: FEI COMPANY, Hillsboro, OR 97124 (US)
(72) Inventor: ZAKOPAL, Petr, Brno (CZ); VASINA, Radovan, Brno (CZ)
(74) Representative: Boult Wade Tennant LLP

(57) **Abstract**

Systems or techniques are provided for magnetic magnification control of electron microscopes. In various embodiments, a system can comprise an electron microscope that diffracts electrons through an analytical sample and modifies, using one or more magnetic immersion fields, trajectories of the electrons onto an electron detector.

## Description

### Background

Electron microscopes utilize fixed position electron detectors. This causes fixed camera length and forces a tradeoff between the benefits of longer and shorter camera lengths, thus limiting the versatility of the electron microscopes if there is not an optical system that can alter it.

### Summary

The following presents a summary to provide a basic understanding of one or more embodiments. This summary is not intended to identify key or critical elements, or delineate any scope of the particular embodiments or any scope of the claims. Its sole purpose is to present concepts in a simplified form as a prelude to the more detailed description that is presented later. In one or more embodiments described herein, devices, systems, computer-implemented methods, apparatus or computer program products that facilitate improved resolution and effective demagnification of electron microscopes are provided.

According to one or more embodiments, a system is provided. The system can comprise an electron microscope that diffracts electrons through an analytical sample and modifies, using one or more magnetic immersion fields, trajectories of the electrons onto an electron detector. The scientific instrument can further comprise a non-transitory computer-readable memory that can store computer-executable components. The system can further comprise a processor that can be operably coupled to the non-transitory computer-readable memory and that can execute the computer-executable components stored in the non-transitory computer-readable memory. In various embodiments, the computer-executable components can comprise an image correction component that generates an image of a diffraction pattern of the electrons that impinge on the electron detector.

An advantage of the system, and/or of a corresponding computer-implemented method and/or computer program product can be the ability to enable demagnification, and thus zoom control, with the use of a fixed position electron detector and without additional hardware. This demagnification can enable capturing of portions of the diffraction pattern that may have otherwise fallen outside the area of the electron detector.
Further aspects of the invention are set out in the following numbered clauses:
1. A system comprising:
   an electron microscope that diffracts electrons through an analytical sample and
   modifies, using one or more magnetic immersion fields, trajectories of the electrons onto an electron detector.
2. The system of clause 1, further comprising:
   a memory that stores computer executable components;
   a processor that executes the computer executable components stored in the memory, wherein the computer executable components comprise:
      an image correction component that generates an image of a diffraction pattern of the electrons that impinge on the electron detector.
3. The system of clause 2, wherein the modifying comprises exciting the one or more magnetic immersion fields by a given value of ampere-turns and wherein the computer executable components further comprise a trajectory modification component that determines the given value of ampere-turns, such that at a given electron landing energy, trajectories of the electrons are directed onto the electron detector.
4. The system of clause 1, wherein initial trajectories before modification of one or more of the electrons fall outside of the area of the electron detector.
5. The system of clause 2, wherein the image correction component further executes one or more digital corrections to correct deviation of the image of the diffraction pattern.
6. The system of clause 1, wherein the electron microscope comprises at least one of a scanning electron microscope or a dual beam microscope.
7. The system of clause 1, wherein the one or more magnetic immersion fields are generated by one or more magnetic immersion lens or one or more magnetic coils.
8. A method, comprising:
   diffracting, by an electron microscope, electrons through an analytical sample; and
   modifying, by one or more magnetic immersion fields, trajectories of the electrons onto an electron detector of the electron microscope.
9. The method of clause 8, further comprising:
   generating, by a device operatively coupled to a processor, an image of a diffraction pattern of the electrons that impinge on the electron detector.
10. The method of clause 9, wherein the modifying comprises exciting the one or more magnetic immersion fields by a given value of ampere-turns.
11. The method of clause 10, further comprising:
   determining, by the device, the given value of ampere-turns, such that at a given electron landing energy, trajectories of the electrons are directed onto the electron detector.
12. The method of clause 8, wherein initial trajectories before modification of one or more of the electrons fall outside the area of the electron detector.
13. The method of clause 9, further comprising, correcting, by the device, deviation of the image of the diffraction pattern.
14. The method of clause 8, wherein the one or more magnetic immersion fields are generated by one or more magnetic immersion lens or one or more magnetic coils.
15. A computer program product comprising a non-transitory computer-readable memory having program instructions embodied therewith, the program instructions executable by a processor to cause the processor to:
   diffract, by the processor, using an electron microscope, electrons through an analytical sample; and
   modify, by the processor, using one or more magnetic immersion fields, trajectories of the electrons onto an electron detector of the electron microscope.
16. The computer program product of clause 15, wherein the program instructions are further executable by the processor, to cause the processor to:
   generate an image of a diffraction pattern of the electrons that impinge on the electron detector.
17. The computer program product of clause 15, wherein the modifying comprises exciting the one or more magnetic immersion fields by a given value of ampere-turns, such that at a given electron landing energy, trajectories of the electrons are directed onto the electron detector.
18. The computer program product of clause 16, wherein the program instructions are further executable by the processor, to cause the processor to:
   correct, by the processor, deviation of the image of the diffraction pattern.
19. The computer program product of clause 15, wherein the electron microscope comprises at least one of a scanning electron microscope or a dual beam microscope.
20. The computer program product of clause 15, wherein the one or more magnetic immersion fields are generated by one or more magnetic immersion lens or one or more magnetic coils.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a block diagram of an example scientific instrument module for performing magnetic immersion field demagnification, in accordance with various embodiments described herein.
FIG. 2 is a flow diagram of an example, non-limiting, method of performing magnetic immersion field demagnification, in accordance with various embodiments described herein.
FIG. 3 illustrates a block diagram of example, non-limiting, scientific instruments that facilitate magnetic immersion field demagnification in accordance with one or more embodiments described herein.
FIG. 4 illustrates a diagram of an electron microscope without the use of magnetic demagnification in accordance with one or more embodiments described herein.
FIG. 5 illustrates a diagram of an electron microscope with the use of magnetic demagnification in accordance with one or more embodiments described herein.
FIG. 6 illustrates a diagram of a magnetic immersion field being applied to a diffraction stream of electrons in accordance with one or more embodiments described herein.
FIG. 7 illustrates a flow diagram of diffraction pattern images with magnetic demagnification in accordance with one or more embodiments described herein.
FIG. 8 illustrates a graph showing the relationship between the ampere-turns value of the magnetic immersion field and the effective camera length of the diffraction pattern images produced in accordance with one or more embodiments described herein.
FIG. 9 illustrates a graph showing the relationship between the ampere-turns value of the magnetic immersion field and the magnification of the diffraction pattern images produced in accordance with one or more embodiments described herein.
FIG. 10 illustrates a graph showing the relationship between magnetic demagnification and electron detector resolution in accordance with one or more embodiments described herein.
FIG. 11 illustrates a flow diagram of an example, non-limiting, computer-implemented method that can facilitate demagnification in electron microscopes in accordance with one or more embodiments described herein.
FIG. 12 illustrates a block diagram of an example, non-limiting, operating environment in which one or more embodiments described herein can be facilitated.

### Detailed Description

The following detailed description is merely illustrative and is not intended to limit embodiments and/or application or utilization of embodiments. Furthermore, there is no intention to be bound by any expressed or implied information presented in the preceding Summary section, or in the Detailed Description section. One or more embodiments are now described with reference to the drawings, wherein like reference numerals are utilized to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

In certain branches of electron microscopy, electrons are directed through an electron transparent sample, diffracting the stream of the electrons, which are then collected on an electron detector to generate an image of a diffraction pattern. Before the experiment, the electron detector is inserted at a fixed length or position (e.g., the camera length) below the sample. This presents a choice between a longer camera length, which provides better reciprocal space resolution, but limits the reciprocal space range and may cause some defection spots to fall outside of the surface area of the detector, or a shorter camera length, which provides better coverage but decreased reciprocal space resolution. Furthermore, as electron microscope performance improves to allow for analysis of 2D materials down to 5-6 keV, the effects of increased electron wavelength and higher Bragg angles makes the reciprocal space range constraints even more serious. Additionally, changing the physical location of the electron detector between experiments can be time consuming and risks damage to components of the electron microscope.

To overcome the one or more deficiencies of existing technologies as identified above, one or more embodiments described herein can diffract, by an electron microscope, electrons through an analytical sample, and modify, by one or more magnetic immersion fields, trajectories of the electrons onto an electron detector of the electron microscope. In this manner, electrons and/or diffraction spots that may ordinarily miss the electron detector, and thus not be captured, can be directed onto the electron detector, thus capturing a more accurate representation of the sample and effectively acting as a demagnification or zoom-out of the diffraction pattern. By varying the value of ampere-turns, the trajectories of the electrons are modified to varying degrees, thus allowing for variable magnification control, without the need to physically move components, such as the electron detector, within the electron microscope.

Furthermore, an image of the diffraction pattern can be generated based on the detected diffraction spots. The application of the magnetic immersion fields may cause unintended rotation of the diffraction pattern. Accordingly, one or more digital image rotation corrections can be applied to correct the image of the diffraction pattern. Therefore, the embodiments described herein facilitate usage of magnetic field effects on diffraction patterns to enable magnification control. By calibrating the effects of demagnification and rotation on the diffraction patterns, digital image post-processing can correct any deviation from the expected form, such as rotation, that may occur as a result of the magnetic immersion field.

One or more embodiments are now described with reference to the drawings, where like referenced numerals are used to refer to like elements throughout. In the following description, for purposes of explanation, numerous specific details are set forth to provide a more thorough understanding of the one or more embodiments. It is evident in various cases, however, that the one or more embodiments can be practiced without these specific details.

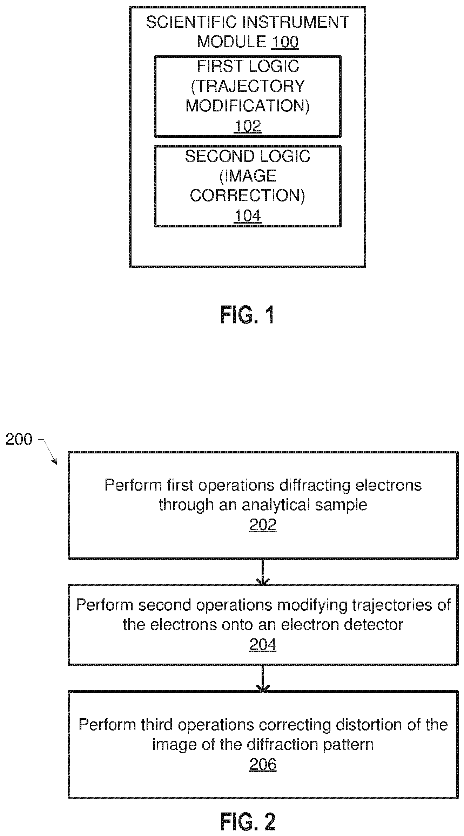

FIG. 1 illustrates an example, non-limiting block diagram of a scientific instrument module 100 in accordance with various embodiments described herein.

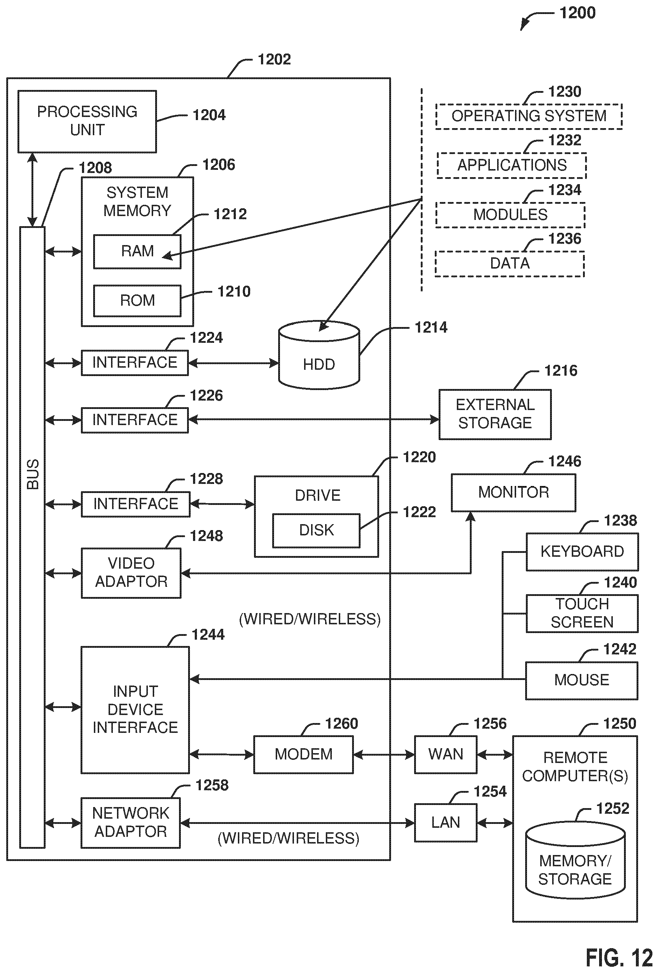

In various embodiments, the scientific instrument module 100 can be implemented by circuitry (e.g., including electrical or optical components), such as a programmed computing device. Logic of the scientific instrument module 100 can be included in a single computing device or can be distributed across multiple computing devices that are in communication with each other as appropriate. Examples of computing devices that may, singly or in combination, implement the scientific instrument module 100 are discussed herein with reference to FIG. 12.

The scientific instrument module 100 may include first logic 102 and second logic 104. As used herein, the term "logic" may include an apparatus that is to perform a set of operations associated with the logic elements. For example, any of the logic elements included in the scientific instrument module 100 may be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" may refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module may not include all of the logic elements depicted in the associated drawing; for example, a module may include a subset of the logic elements depicted in the associated drawing when that module is to perform a subset of the operations discussed herein with reference to that module.

In various embodiments, there can be a scientific instrument corresponding to the scientific instrument module 100. In various aspects, the scientific instrument can be any suitable computerized device that can electronically measure some scientifically-relevant, clinically-relevant, or research-relevant characteristic, property, or attribute of an analytical sample (e.g., of a known or unknown mixture, compound, or collection of matter). As a non-limiting example, a scientific instrument can be an electron microscope.

The first logic 102 may determine how to excite one or more magnetic immersion fields to modify the trajectories of the electrons. For example, modifying, or bending, of the trajectories of electron streams can be achieved through the use of a Lorentz force using a variable excitation, measured in ampere-turns, applied to one or more magnetic immersion lens or magnetic coils within the electron microscope. Accordingly, an amount of desired demagnification (e.g., zoom-out) can be determined based on a given value of ampere-turns and the landing energy of the electrons. First logic 102 can then cause the constituent hardware of the electron microscope to apply the appropriate magnetic immersion field.

The second logic 104 may perform one or more image corrections on the diffraction pattern generated by the modification of the electron trajectories. For example, at given values of ampere-turns, the diffraction pattern will be rotated by the magnetic immersion field a given amount. Accordingly, a rotation correction can be applied to the image of the diffraction pattern based on the applied value of ampere-turns and the accelerating voltage to produce a rotation corrected and demagnified diffraction pattern.

FIG. 2 is a flow diagram of a computer-implemented method 200 in accordance with one or more embodiments described herein. The operations of the computer-implemented method 200 may be used in any suitable setting to perform any suitable operations (e.g., can be performed by or used in conjunction with any of the various modules, computing devices, or graphical user interfaces described with respect to of FIGS. 1, 7, 8, 9, and 10). Operations are illustrated once each and in a particular order in FIG. 2, but the operations may be reordered or repeated as desired and appropriate (e.g., different operations performed may be performed in parallel, as suitable).

At 202, first operations may be performed. For example, the first logic 102 of scientific instrument module 100 may perform the operations of 202. The first operations may include diffracting electrons through an analytical sample by the electron microscope.

At 204, second operations may be performed. For example, the first logic 102 of scientific instrument module 100 may perform the operations of 204. The second operations may include determining the value of ampere-turns to apply to the magnetic immersion fields, and then applying said field to the electron stream by the constituent hardware of the electron microscope.

At 206, third operations may be performed. For example, the second logic 104 of scientific instrument module 100 may perform the operations of 206. The third operations may include applying a digital rotation correction to the diffraction pattern based on the applied ampere-turns and the accelerating voltage used by the electron microscope.

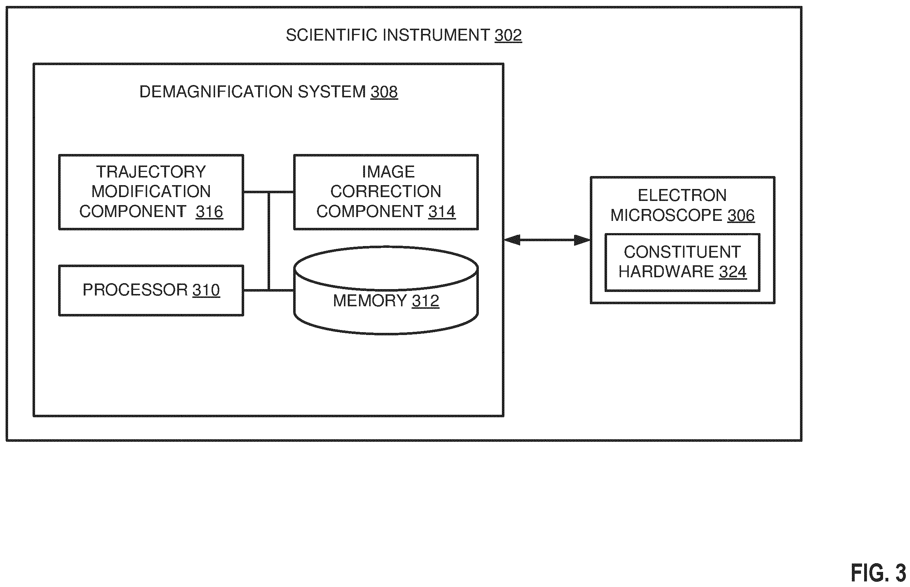

FIG. 3 illustrates a block diagram of an example, non-limiting scientific instrument that can facilitate magnification control of electron microscopes in accordance with one or more embodiments described herein. As shown, scientific instrument 302 can comprise an electron microscope 306.

In various aspects, the electron microscope 306 can be any suitable electron microscope. In various instances, the electron microscope 306 can comprise any suitable constituent hardware 324 for generating electron microscopy images and generating magnetic immersion fields. In various cases, the electron microscope 306 can comprise a scanning electron microscope that can measure or determine a surface topography of an analytical sample or a dual beam microscope. In another non-limiting example, the electron microscope 306 can comprise a transmission electron microscope that can measure or determine internal structural details of the analytical sample. In a further, non-limiting, example, the electron microscope 306 can comprise any suitable type of charges-particle microscope (e.g., types of microscopes that use beams of non-electron ions to capture images). Further examples of electron microscope 306 include, but are not limited to, energy dispersive spectroscopy, electron energy loss spectroscopy, and electron backscatter diffraction spectroscopy.

In any case, when given an analytical sample, the electron microscope 306 can produce an input image of the whole or a portion of the analytical sample by diffracting a stream of electrons through the analytical sample and onto an electron detector.

In various embodiments, the scientific instrument 302 can comprise a demagnification system 308. In various cases the demagnification system 308 can facilitate effective magnification/demagnification control of electron microscope 306.

In various aspects, the demagnification system 308 can comprise a processor 310 (e.g., computer processing unit, microprocessor) and a non-transitory computer-readable memory 312 that is operably or operatively or communicatively connected or coupled to the processor 310. The non-transitory computer-readable memory 312 can store computer-executable instructions which, upon execution by the processor 310, can cause the processor 310 or other components of the demagnification system 308 (e.g., trajectory modification component 316 and/or image correction component 314) to perform one or more acts. In various embodiments, the non-transitory computer-readable memory 312 can store computer-executable components (e.g., trajectory modification component 316 and/or image correction component 314), and the processor 310 can execute the computer-executable components.

In various embodiments, the demagnification system 308 can comprise a trajectory modification component 316. In various aspects, the trajectory modification component 316 can determine a value of ampere-turns to excite one or more magnetic immersion fields to produce a desired amount of demagnification. For example, trajectory modification component 316 can receive a command from an entity such as a user operating electron microscope 306 to demagnify (e.g., zoom out) an image of a diffraction pattern by a specific amount. As the reaction of electrons to magnetic fields is predictable, the value of ampere-turns can be determined based on factors such as the electron landing energy, geometry of the polepieces and electron beam energy in the electron beam column. In simple cases, the landing electron energy is numerically equal to that of the acceleration voltage. In cases involving the use of booster tube systems, the variance in energy of the electron beam due to the relative position in the column can be taken into account.

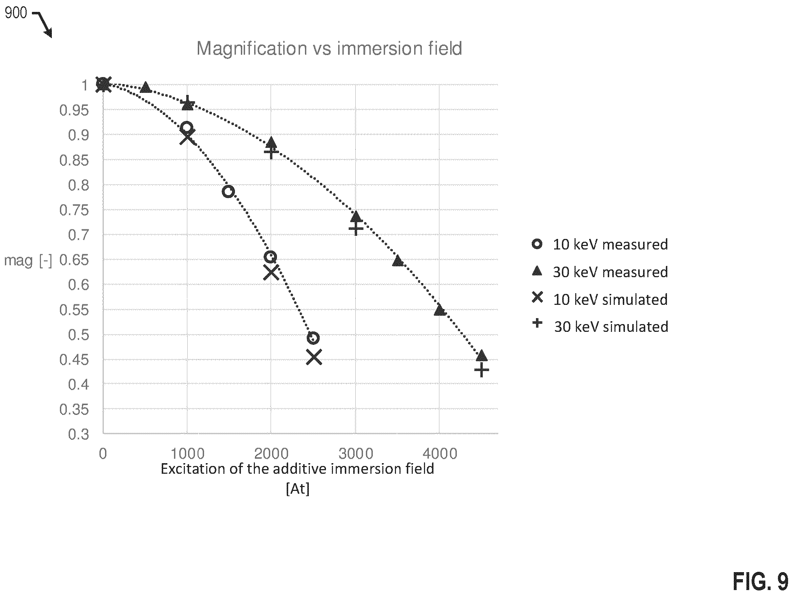

Once determined, trajectory modification component 316 can cause the constituent hardware 324 of electron microscope 306 to apply the magnetic immersion field at the given value of ampere-turns. The magnetic immersion field can modify or bend the trajectories of electrons, causing electrons or diffraction spots that may otherwise miss the electron detector of electron microscope 306 to instead impinge on the detector, thereby capturing a more complete version of the diffraction pattern. This allows for additional features to be captured by the electron detector, that otherwise may not have been due to the camera length, such as higher-order Laue Zone (HOLZ) rings. FIG. 9, described in detail below, illustrates a graph showing the value of ampere-turns to apply to achieve a specific amount of demagnification.

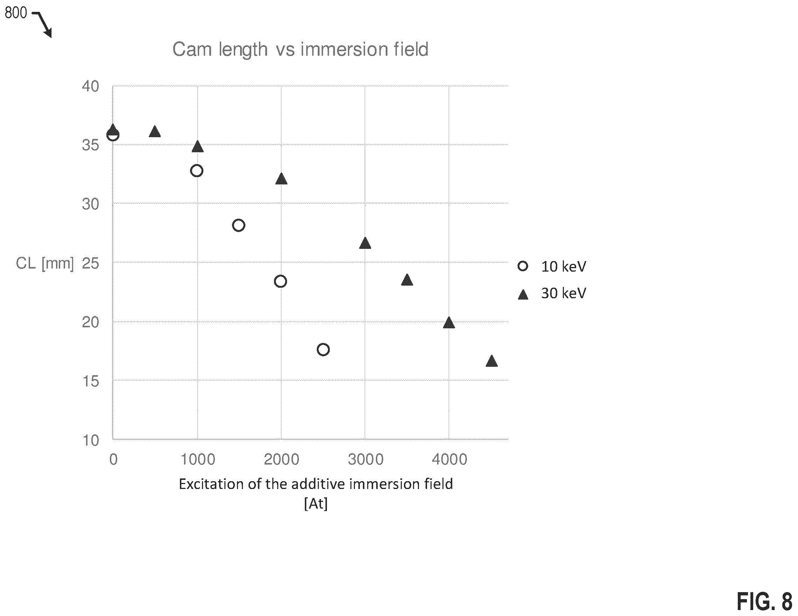

Similarly, trajectory modification component 316 can receive an effective camera length distance and determine the value of ampere-turns to utilize to demagnify the diffraction pattern such that it approximates the diffraction pattern captured utilizing that physical camera length. Through this application of magnetic immersion fields, the effective zoom or camera length of the electron microscope can be controlled, without movement of the electron detector. FIG. 8, described in detail below, illustrates a graph showing the value of ampere-turns to apply to achieve a specific amount of camera length. Accordingly, the electron detector may be placed at a farther camera length, to enable high magnification and better precision processing, while the demagnification offered by the application of the magnetic immersion field provides the benefit of shorter camera lengths, that of more reciprocal space and capturing a larger portion of the overall diffraction pattern.

In various embodiments, the demagnification system 308 can comprise image correction component 314. In various aspects, image correction component 314 can generate an image of a diffraction pattern captured by the electron detector of electron microscope 306. For example, a digital image can be created showing the diffraction pattern as it impinged on the electron detector.

In various aspects image correction component 314 can further correct distortion or deviation of the diffraction patterns images generated using electron microscope 306. In some cases, the application of the magnetic immersion field can cause deviation, such as rotation, of the diffraction pattern, thus creating deviation in the images generated by image correction component 314. For example, the application of magnetic immersion fields can cause rotation of diffraction patterns, which is then represented in the image of the diffraction pattern. This can create issues during analysis, as diffraction spots in the image will not be in the correct position relative to the portions of the analytical sample that caused the diffraction spot.

Accordingly, image correction component 314 can apply one or more digital transformations to correct the rotation. For example, at given value of ampere-turns and electron beam landing energy, the diffraction pattern will be rotated by a given amount. Therefore, given the value of ampere-turns, and the electron landing energy, image correction component 314 can apply the appropriate amount of counter-rotation to correct the image. In another embodiment, image correction component 314 can determine an appropriate amount of counter-rotation based on an initial diffraction pattern. For example, first a magnified (e.g., with no magnetic immersion field applied) diffraction pattern image can be generated. Image correction component 314 can note the relative orientation of various diffraction spots in the image. Then, when provided with a demagnified diffraction pattern image, image correction component 314 can apply an amount of counter-rotation such that the relative orientation of the various diffraction spots is the same in both the magnified and demagnified diffraction pattern images. In this manner, rotation of the diffraction pattern image can be corrected, thus providing a more accurate representation of the sample.

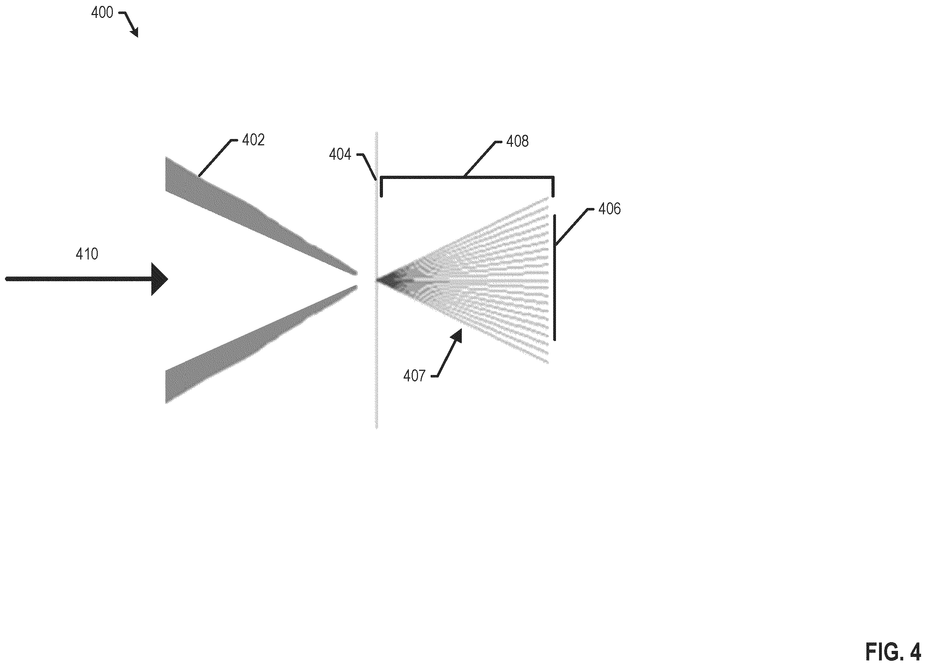

FIG. 4 illustrates a diagram of an electron microscope without the use of magnetic demagnification in accordance with one or more embodiments described herein.

As shown the electron microscope 400 comprises a final lens402 of a electron microscope which directs electrons to the sample 404 along direction 410. The electrons are diffracted by sample 404, creating diffraction pattern 408. However, as shown, the outer edges of the diffracted electrons 407 extend past the edges of electron detector 406. Accordingly, the outer regions of the diffraction pattern 408 will not be captured by the detector 406, thus producing an incomplete diffraction pattern image. While electron detector 406 could be positioned closer to sample 404 to capture more of the diffraction pattern, this would decrease camera length, and thus cause the issues related to short camera length previously discussed above.

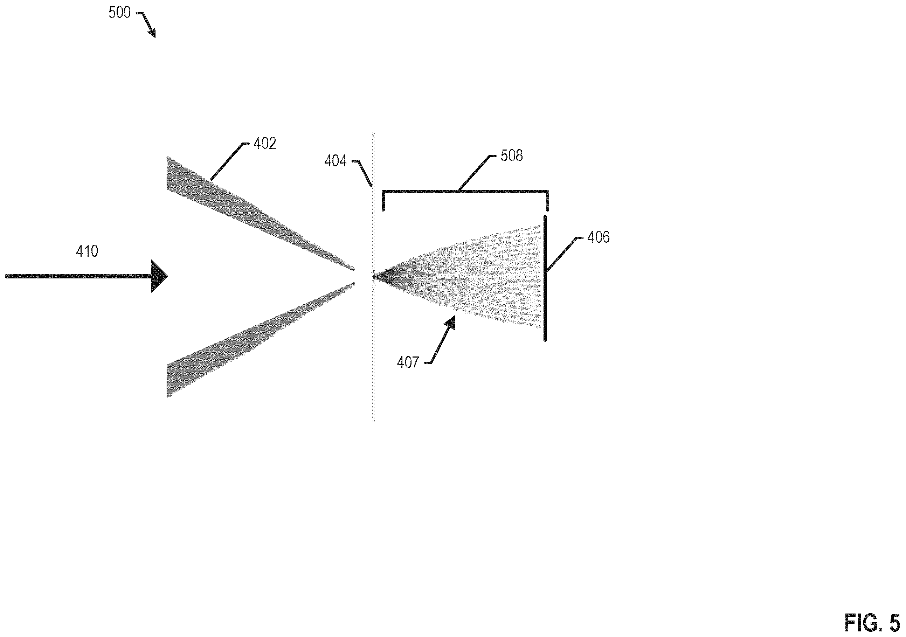

FIG. 5 illustrates a diagram of an electron microscope with the use of magnetic demagnification in accordance with one or more embodiments described herein.

As described above in relation to FIGS. 1-3 a magnetic immersion field can be applied to electrons diffracted through sample 404. As shown in FIG. 5, diffraction pattern 508 is tighter due to the use of the magnetic immersion field, and thus all the diffracted electrons 407 impinges on electron detector 406. Therefore, the entirety of the diffraction pattern is captured. As described above, this has the effect of demagnification, generating a diffraction pattern image that appears zoomed out, without the need to physically change the camera length (e.g., relative position of electron detector 406). Furthermore, electron detector 406 is placed in the same location as that in FIG. 4. Thus FIG. 5 utilizes the same camera length, and thus the same reciprocal space resolution, while also capturing the whole of the diffraction pattern.

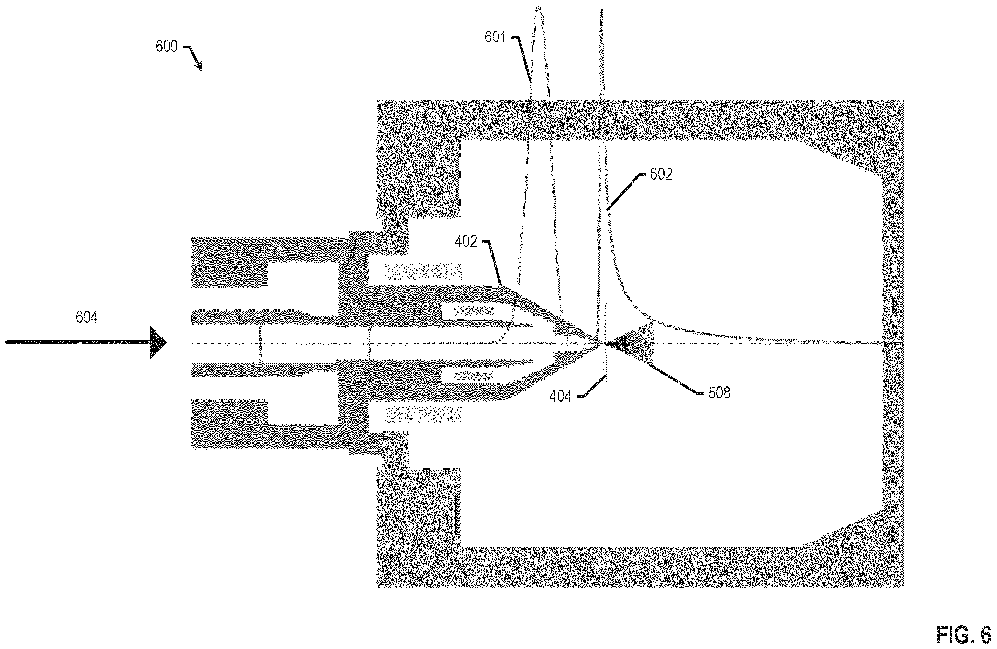

FIG. 6 illustrates a diagram of a magnetic immersion field being applied to a diffraction stream of electrons in accordance with one or more embodiments described herein.

As shown, additive magnetic immersion field 602 is being applied to the diffracted electrons to produce diffraction pattern 508. The magnetic focusing field 601 is used for getting a smallest possible beam spot at the sample 404. Arrow 604 illustrates the primary direction in which the electron beam is traveling. In one or more embodiments, the magnetic immersion field 602 can be generated using one or more magnetic immersion lens within the electron microscope. In another embodiment, the electron microscope can comprise one or more magnetic coils positioned specifically to generate the magnetic immersion field. As described above in relation to FIGS. 1-3, magnetic immersion field 602 can be applied to achieve a specific amount of demagnification. For example, an entity operating the electron microscope can specify an amount of demagnification to apply. Trajectory modification component 316 can then determine a value of ampere-turns to apply based on the landing energy of the electrons and the specified amount of demagnification. Similarly, as described above in relation to FIGS. 1-3, magnetic immersion field 602 can be applied to achieve a specific camera length. For example, an entity operating the electron microscope can specify a camera length to utilize. Trajectory modification component 316 can then determine a value of ampere-turns to apply based on the landing energy of the electrons and the specified camera length.

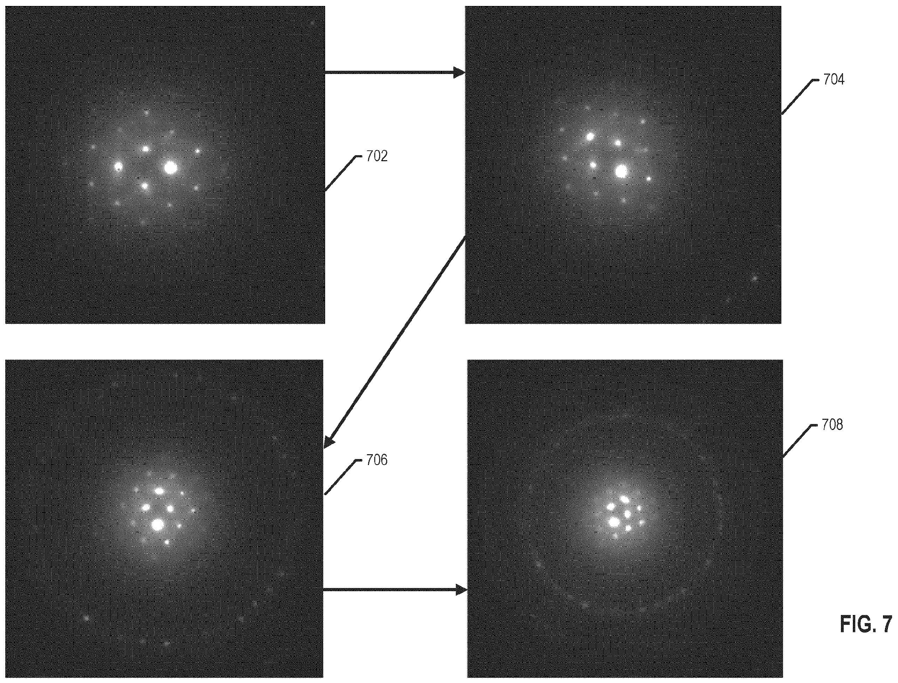

FIG. 7 illustrates a flow diagram of diffraction pattern images with magnetic demagnification in accordance with one or more embodiments described herein.

As shown, image 702 shows a diffraction pattern with no magnetic demagnification applied (e.g., magnification of 1). Images 704, 706 and 708 illustrate the effects of increased demagnification (e.g., a magnetic immersion field with an increased number of ampere-turns). As illustrated, as the value of ampere-turns is increased, the diffraction pattern becomes demagnified, or zoomed out, so that in images 706 and 708 a higher-order Laue Zone ring becomes visible at the outer edges of the diffraction pattern. This ring was not captured in images 702 and 704, due to some of the electrons missing the electron detector.

Additionally, as shown, as the value of ampere-turns increases, the diffraction pattern rotates in this example in a counterclockwise manner. Accordingly, to correct this rotation deviation, image correction component 314 can apply in this example a clockwise rotation correction, such that the relative orientations of image 702 and 708 are the same when output to the entity operating the electron microscope. Furthermore, in one or more embodiments, image correction component 314 can apply one or more digital transformation to correct geometrical deviation as described above in relation to FIG. 3.

FIG. 8 illustrates graph 800 showing the relationship between the ampere-turns value of the magnetic immersion field and the effective camera length of the diffraction pattern images produced in accordance with one or more embodiments described herein. The y-axis of graph 800 illustrates the effective camera length of the electron microscope and the x-axis of graph 800 illustrates the excitation of the additive immersion field utilized. Data points are shown for both 10 keV and 30 keV settings of an electron microscope. As shown, for the data collected in FIG. 8, the actual camera length (e.g., the physical distance of the electron detector) is 35 mm. As the value of ampere-turns is increased, the effective camera length due to the demagnification effect is decreased, beginning at approximately 1000 ampere-turns. Accordingly, when given an effective camera length value by an entity operating the electron microscope, trajectory modification component 316 can determine an appropriate value of ampere-turns utilizing graph 800 and the power setting of the electron microscope.

FIG. 9 illustrates graph 900 showing the relationship between the ampere-turns value of the magnetic immersion field and the magnification of the diffraction pattern images produced in accordance with one or more embodiments described herein. The y-axis of graph 900 illustrates the magnification power of the electron microscope and the x-axis of graph 900 illustrates the value of ampere-turns utilized. Data points are shown for both 10 keV and 30 keV settings of an electron microscope, both practically and in simulation. As shown, as the value of ampere-turns is increased, the magnification level is decreased. Accordingly, when given a magnification level by an entity operating the electron microscope, trajectory modification component 316 can determine an appropriate value of ampere-turns utilizing graph 900 and the power setting of the electron microscope.

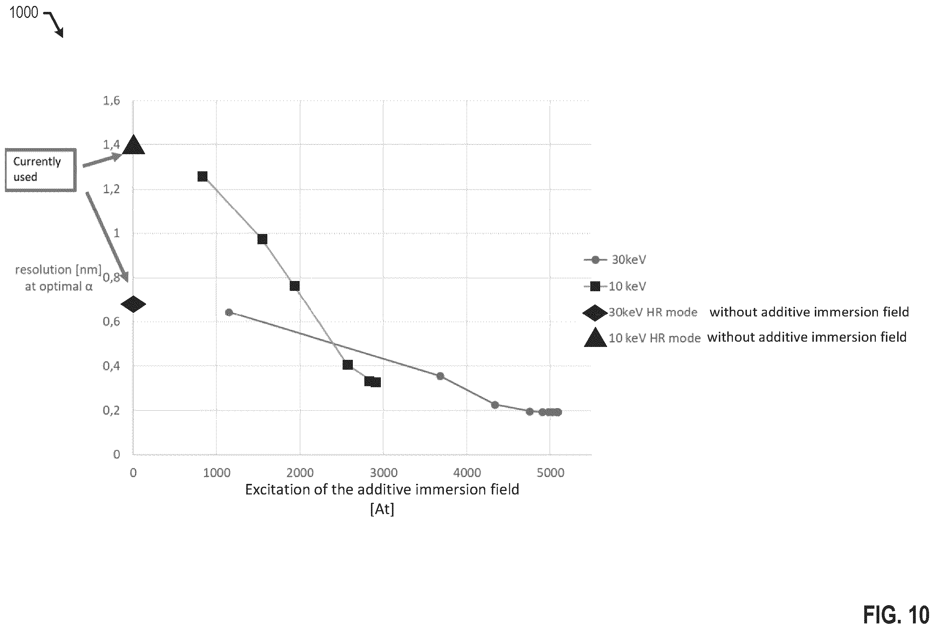

FIG. 10 illustrates graph 1000 showing the relationship between lateral resolution and excitation of the additional magnetic immersion field in accordance with one or more embodiments described herein. The y-axis of graph 1000 illustrates the lateral resolution and reciprocal space in nm and the x-axis of graph 1000 illustrates the excitation of the additive immersion field utilized . As shown, when operating in 10 keV mode, the lateral resolution can be improved from ~1.4 nm to ~0.35 nm while using additive immersion field. When operating in 30 keV mode, the lateral resolution can be improved from 0.7 nm to 0.2 nm.

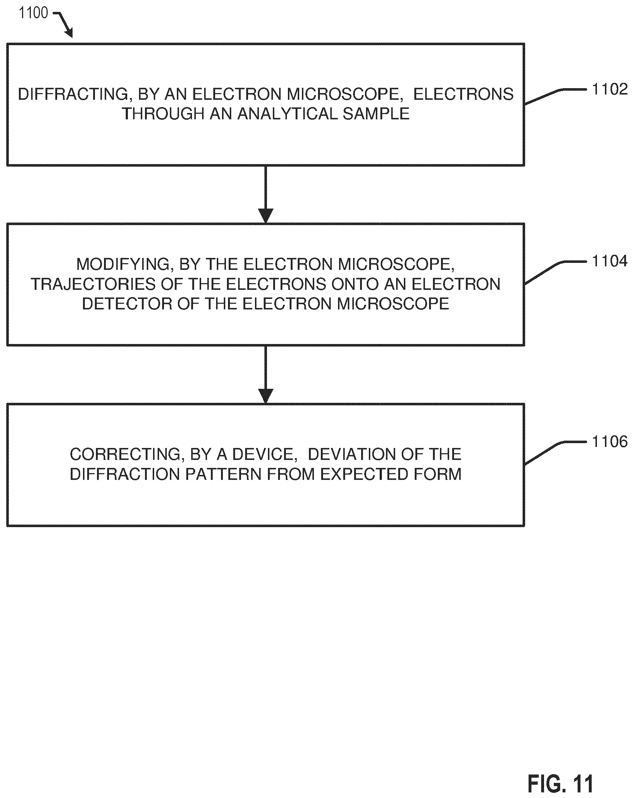

FIG. 11 illustrates a flow diagram of an example, non-limiting, computer-implemented method 1100 that can facilitate demagnification in electron microscopes in accordance with one or more embodiments described herein.

In various embodiments, act 1102 can comprise diffracting, by an electron microscope (e.g., electron microscope 306), electrons through an analytical sample. For example, an electron microscope can accelerate an electron beam towards a sample, which then pass through the sample and are diffracted, creating diffraction spots.

In various embodiments, act 1104 can comprise modifying, by the electron microscope, trajectories of the electrons onto an electron detector of the electron microscope. For example, as described above in relation to FIGS. 1-3 an entity operating the electron microscope can specify an effective camera length or a magnification to utilize, based on the electron landing energy and the specified camera length and/or magnification, a computer executable component, such as trajectory modification component 316, can determine a value of ampere-turns to utilized in a magnetic immersion field to achieve the specified camera length or demagnification. As described above in relation to FIGS. 8 and 9 an excitation of between approximately 1000 and 4000 ampere-turns can be utilized to provide effective demagnification. The constituent hardware of electron microscope 306 can then apply a magnetic immersion field to modify the trajectories of the electrons diffracted through the sample to produce the desired effective camera length or magnification. Furthermore, some of the diffraction spots of the diffraction pattern may ordinarily miss the electron detector due to the physical camera length. Accordingly, by modifying the trajectories of one or more of the electrons, all or a greater portion of the diffraction spots may impinge on the electron detector, thus capturing a more complete diffraction pattern.

In various embodiments, act 1106 can comprise correcting, by a device (e.g., image correction component 314) deviation of the image of the diffraction pattern from the expected form. For example, as described above in relation to FIGS. 1-7, application of the magnetic immersion field can cause rotation of the diffraction patterns. Accordingly, given the electron landing energy and the value of ampere-turns applied, image correction component 314 can apply a digital transformation to the image to correct for the rotation.

An advantage of the systems, and/or of corresponding computer-implemented methods and/or computer program products described herein can be the ability to enable demagnification and adjustment of effective camera length, without modification of the physical location of an electron detector within an electron microscope. This provides the ability to easily change the magnification, thus enabling both the benefits of higher and lower camera lengths, and the flexibility to easily change magnification without the need to adjust physical components. This can allow for faster performance of multiple experiments, as physical modification of the electron microscope is not needed to capture diffraction pattern images of different camera lengths. Additionally, as described above in relation to FIG. 10, this can enable improvements in resolution allowing for clear imaging of smaller objects than previously possible. Furthermore, by applying one or more post-processing image techniques, any expected deviation in the diffraction pattern that may occur due to the application of the magnetic immersion field can be corrected, thus producing accurate and representative diffraction pattern images.

In various instances, machine learning algorithms or models can be implemented in any suitable way to facilitate any suitable aspects described herein. To facilitate some of the above-described machine learning aspects of various embodiments, consider the following discussion of artificial intelligence (Al). Various embodiments described herein can employ artificial intelligence to facilitate automating one or more features or functionalities. The components can employ various Al-based schemes for carrying out various embodiments/examples disclosed herein. In order to provide for or aid in the numerous determinations (e.g., determine, ascertain, infer, calculate, predict, prognose, estimate, derive, forecast, detect, compute) described herein, components described herein can examine the entirety or a subset of the data to which it is granted access and can provide for reasoning about or determine states of the system or environment from a set of observations as captured via events or data. Determinations can be employed to identify a specific context or action, or can generate a probability distribution over states, for example. The determinations can be probabilistic; that is, the computation of a probability distribution over states of interest based on a consideration of data and events. Determinations can also refer to techniques employed for composing higher-level events from a set of events or data.

Such determinations can result in the construction of new events or actions from a set of observed events or stored event data, whether or not the events are correlated in close temporal proximity, and whether the events and data come from one or several event and data sources. Components disclosed herein can employ various classification (explicitly trained (e.g., via training data) as well as implicitly trained (e.g., via observing behavior, preferences, historical information, receiving extrinsic information, and so on)) schemes or systems (e.g., support vector machines, neural networks, expert systems, Bayesian belief networks, fuzzy logic, data fusion engines, and so on) in connection with performing automatic or determined action in connection with the claimed subject matter. Thus, classification schemes or systems can be used to automatically learn and perform a number of functions, actions, or determinations.

A classifier can map an input attribute vector, z = (z1, z2, z3, z4, zn), to a confidence that the input belongs to a class, as by f(z) = confidence(class). Such classification can employ a probabilistic or statistical-based analysis (e.g., factoring into the analysis utilities and costs) to determinate an action to be automatically performed. A support vector machine (SVM) can be an example of a classifier that can be employed. The SVM operates by finding a hyper-surface in the space of possible inputs, where the hyper-surface attempts to split the triggering criteria from the non-triggering events. Intuitively, this makes the classification correct for testing data that is near, but not identical to training data. Other directed and undirected model classification approaches include, e.g., naïve Bayes, Bayesian networks, decision trees, neural networks, fuzzy logic models, or probabilistic classification models providing different patterns of independence, any of which can be employed. Classification as used herein also is inclusive of statistical regression that is utilized to develop models of priority.

In order to provide additional context for various embodiments described herein, FIG. 11 and the following discussion are intended to provide a brief, general description of a suitable computing environment 1100 in which the various embodiments of the embodiment described herein can be implemented. While the embodiments have been described above in the general context of computer-executable instructions that can run on one or more computers, those skilled in the art will recognize that the embodiments can be also implemented in combination with other program modules or as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multi-processor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 12, the example environment 1200 for implementing various embodiments of the aspects described herein includes a computer 1202, the computer 1202 including a processing unit 1204, a system memory 1206 and a system bus 1208. The system bus 1208 couples system components including, but not limited to, the system memory 1206 to the processing unit 1204. The processing unit 1204 can be any of various commercially available processors. Dual microprocessors and other multi processor architectures can also be employed as the processing unit 1204.

The system bus 1208 can be any of several types of bus structure that can further interconnect to a memory bus (with or without a memory controller), a peripheral bus, and a local bus using any of a variety of commercially available bus architectures. The system memory 1206 includes ROM 1212 and RAM 1212. A basic input/output system (BIOS) can be stored in a non-volatile memory such as ROM, erasable programmable read only memory (EPROM), EEPROM, which BIOS contains the basic routines that help to transfer information between elements within the computer 1202, such as during startup. The RAM 1212 can also include a high-speed RAM such as static RAM for caching data.

The computer 1202 further includes an internal hard disk drive (HDD) 1214 (e.g., EIDE, SATA), one or more external storage devices 1216 (e.g., a magnetic floppy disk drive (FDD) 1216, a memory stick or flash drive reader, a memory card reader, etc.) and a drive 1220, e.g., such as a solid state drive, an optical disk drive, which can read or write from a disk 1222, such as a CD-ROM disc, a DVD, a BD, etc. Alternatively, where a solid state drive is involved, disk 1222 would not be included, unless separate. While the internal HDD 1214 is illustrated as located within the computer 1202, the internal HDD 1214 can also be configured for external use in a suitable chassis (not shown). Additionally, while not shown in environment 1200, a solid state drive (SSD) could be used in addition to, or in place of, an HDD 1214. The HDD 1214, external storage device(s) 1216 and drive 1220 can be connected to the system bus 1208 by an HDD interface 1224, an external storage interface 1226 and a drive interface 1228, respectively. The interface 1224 for external drive implementations can include at least one or both of Universal Serial Bus (USB) and Institute of Electrical and Electronics Engineers (IEEE) 1294 interface technologies. Other external drive connection technologies are within contemplation of the embodiments described herein.

The drives and their associated computer-readable storage media provide nonvolatile storage of data, data structures, computer-executable instructions, and so forth. For the computer 1202, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 1212, including an operating system 1230, one or more application programs 1232, other program modules 1234 and program data 1236. All or portions of the operating system, applications, modules, or data can also be cached in the RAM 1212. The systems and methods described herein can be implemented utilizing various commercially available operating systems or combinations of operating systems.

Computer 1202 can optionally comprise emulation technologies. For example, a hypervisor (not shown) or other intermediary can emulate a hardware environment for operating system 1230, and the emulated hardware can optionally be different from the hardware illustrated in FIG. 12. In such an embodiment, operating system 1230 can comprise one virtual machine (VM) of multiple VMs hosted at computer 1202. Furthermore, operating system 1230 can provide runtime environments, such as the Java runtime environment or the .NET framework, for applications 1232. Runtime environments are consistent execution environments that allow applications 1232 to run on any operating system that includes the runtime environment. Similarly, operating system 1230 can support containers, and applications 1232 can be in the form of containers, which are lightweight, standalone, executable packages of software that include, e.g., code, runtime, system tools, system libraries and settings for an application.

Further, computer 1202 can be enable with a security module, such as a trusted processing module (TPM). For instance with a TPM, boot components hash next in time boot components, and wait for a match of results to secured values, before loading a next boot component. This process can take place at any layer in the code execution stack of computer 1202, e.g., applied at the application execution level or at the operating system (OS) kernel level, thereby enabling security at any level of code execution.

A user can enter commands and information into the computer 1202 through one or more wired/wireless input devices, e.g., a keyboard 1238, a touch screen 1240, and a pointing device, such as a mouse 1242. Other input devices (not shown) can include a microphone, an infrared (IR) remote control, a radio frequency (RF) remote control, or other remote control, a joystick, a virtual reality controller or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 1204 through an input device interface 1244 that can be coupled to the system bus 1208, but can be connected by other interfaces, such as a parallel port, an IEEE 1294 serial port, a game port, a USB port, an IR interface, a BLUETOOTH^{®} interface, etc.

A monitor 1246 or other type of display device can be also connected to the system bus 1208 via an interface, such as a video adapter 1248. In addition to the monitor 1246, a computer typically includes other peripheral output devices (not shown), such as speakers, printers, etc.

The computer 1202 can operate in a networked environment using logical connections via wired or wireless communications to one or more remote computers, such as a remote computer(s) 1250. The remote computer(s) 1250 can be a workstation, a server computer, a router, a personal computer, portable computer, microprocessor-based entertainment appliance, a peer device or other common network node, and typically includes many or all of the elements described relative to the computer 1202, although, for purposes of brevity, only a memory/storage device 1252 is illustrated. The logical connections depicted include wired/wireless connectivity to a local area network (LAN) 1254 or larger networks, e.g., a wide area network (WAN) 1256. Such LAN and WAN networking environments are commonplace in offices and companies, and facilitate enterprise-wide computer networks, such as intranets, all of which can connect to a global communications network, e.g., the Internet.

When used in a LAN networking environment, the computer 1202 can be connected to the local network 1254 through a wired or wireless communication network interface or adapter 1258. The adapter 1258 can facilitate wired or wireless communication to the LAN 1254, which can also include a wireless access point (AP) disposed thereon for communicating with the adapter 1258 in a wireless mode.

When used in a WAN networking environment, the computer 1202 can include a modem 1260 or can be connected to a communications server on the WAN 1256 via other means for establishing communications over the WAN 1256, such as by way of the Internet. The modem 1260, which can be internal or external and a wired or wireless device, can be connected to the system bus 1208 via the input device interface 1244. In a networked environment, program modules depicted relative to the computer 1202 or portions thereof, can be stored in the remote memory/storage device 1252. It will be appreciated that the network connections shown are example and other means of establishing a communications link between the computers can be used.

When used in either a LAN or WAN networking environment, the computer 1202 can access cloud storage systems or other network-based storage systems in addition to, or in place of, external storage devices 1216 as described above, such as but not limited to a network virtual machine providing one or more aspects of storage or processing of information. Generally, a connection between the computer 1202 and a cloud storage system can be established over a LAN 1254 or WAN 1256 e.g., by the adapter 1258 or modem 1260, respectively. Upon connecting the computer 1202 to an associated cloud storage system, the external storage interface 1226 can, with the aid of the adapter 1258 or modem 1260, manage storage provided by the cloud storage system as it would other types of external storage. For instance, the external storage interface 1226 can be configured to provide access to cloud storage sources as if those sources were physically connected to the computer 1202.

The computer 1202 can be operable to communicate with any wireless devices or entities operatively disposed in wireless communication, e.g., a printer, scanner, desktop or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a predefined structure as with a conventional network or simply an ad hoc communication between at least two devices.

Various non-limiting aspects are described in the following examples.

EXAMPLE 1: A system comprising: an electron microscope that diffracts electrons through an analytical sample and modifies, using one or more magnetic immersion fields, trajectories of the electrons onto an electron detector.

EXAMPLE 2: The system of any preceding example, further comprising: a memory that stores computer executable components; a processor that executes the computer executable components stored in the memory, wherein the computer executable components comprise: an image correction component that generates an image of a diffraction pattern of the electrons that impinge on the electron detector.

EXAMPLE 3: The system of any preceding example, wherein the modifying comprises exciting the one or more magnetic immersion fields by a given value of ampere-turns and wherein the computer executable components further comprise a trajectory modification component that determines the given value of ampere-turns, such that at a given electron landing energy, trajectories of the electrons are directed onto the electron detector.

EXAMPLE 4: The system of any preceding example, wherein initial trajectories before modification of one or more of the electrons fall outside of the area of the electron detector.

EXAMPLE 5: The system of any preceding example, wherein the image correction component further executes one or more digital corrections to correct deviation of the image of the diffraction pattern

EXAMPLE 6: The system of any preceding example, wherein the electron microscope comprises at least one of a scanning electron microscope or a dual beam microscope.

EXAMPLE 7: The system of any preceding example, wherein the one or more magnetic immersion fields are generated by one or more magnetic immersion lens or one or more magnetic coils.

In various aspects, any combination or combinations of EXAMPLES 1-7 can be implemented.

EXAMPLE 8: A method, comprising: diffracting, by an electron microscope, electrons through an analytical sample; and modifying, by one or more magnetic immersion fields, trajectories of the electrons onto an electron detector of the electron microscope.

EXAMPLE 9: The method of any preceding example, further comprising: generating, by a device operatively coupled to a processor, an image of a diffraction pattern of the electrons that impinge on the electron detector.

EXAMPLE 10: The method of any preceding example, wherein the modifying comprises exciting the one or more magnetic immersion fields by a given value of ampere-turns.

EXAMPLE 11: The method of any preceding example, further comprising: determining, by the device, the given value of ampere-turns, such that at a given electron landing energy, trajectories of the electrons are directed onto the electron detector.

EXAMPLE 12: The method of any preceding example, wherein initial trajectories before modification of one or more of the electrons fall outside the area of the electron detector.

EXAMPLE 13: The method of any preceding example, further comprising, correcting, by the device, deviation of the image of the diffraction pattern.

EXAMPLE 14: The method of any preceding example, wherein the one or more magnetic immersion fields are generated by one or more magnetic immersion lens or one or more magnetic coils.

In various aspects, any combination or combinations of EXAMPLES 8-14 can be implemented.

EXAMPLE 15: A computer program product comprising a non-transitory computer-readable memory having program instructions embodied therewith, the program instructions executable by a processor to cause the processor to: diffract, by the processor, using an electron microscope, electrons through an analytical sample; and modify, by the processor, using one or more magnetic immersion fields, trajectories of the electrons onto an electron detector of the electron microscope.

EXAMPLE 16: The computer program product of any preceding example, wherein the program instructions are further executable by the processor, to cause the processor to: generate an image of a diffraction pattern of the electrons that impinge on the electron detector.

EXAMPLE 17: The computer program product of any preceding example, wherein the modifying comprises exciting the one or more magnetic immersion fields by a given value of ampere-turns, such that at a given electron landing energy, trajectories of the electrons are directed onto the electron detector.

EXAMPLE 18: The computer program product of any preceding example, wherein the program instructions are further executable by the processor, to cause the processor to: correct, by the processor, deviation of the image of the diffraction pattern.

EXAMPLE 19: The computer program product of any preceding example, wherein the electron microscope comprises at least one of a scanning electron microscope or a dual beam microscope.

EXAMPLE 20: The computer program product of any preceding example, wherein the one or more magnetic immersion fields are generated by one or more magnetic immersion lens or one or more magnetic coils.

In various aspects, any combination or combinations of EXAMPLES 15-20 can be implemented.

In various aspects, any combination or combinations of EXAMPLES 1-20 can be implemented.

## Claims

1. A system comprising:
an electron microscope that diffracts electrons through an analytical sample and modifies, using one or more magnetic immersion fields, trajectories of the electrons onto an electron detector.

2. The system of claim 1, further comprising:
a memory that stores computer executable components;
a processor that executes the computer executable components stored in the memory, wherein the computer executable components comprise:
an image correction component that generates an image of a diffraction pattern of the electrons that impinge on the electron detector.

3. The system of claim 2, wherein the modifying comprises exciting the one or more magnetic immersion fields by a given value of ampere-turns and wherein the computer executable components further comprise a trajectory modification component that determines the given value of ampere-turns, such that at a given electron landing energy, trajectories of the electrons are directed onto the electron detector.

4. The system of any of claims 2-3, wherein the image correction component further executes one or more digital corrections to correct deviation of the image of the diffraction pattern.

5. The system of any of claims 1-4, wherein initial trajectories before modification of one or more of the electrons fall outside of the area of the electron detector.

6. The system of any of claims 1-5, wherein the electron microscope comprises at least one of a scanning electron microscope or a dual beam microscope.

7. The system of any of claims 1-6, wherein the one or more magnetic immersion fields are generated by one or more magnetic immersion lens or one or more magnetic coils.

8. A method, comprising:
diffracting, by an electron microscope, electrons through an analytical sample; and
modifying, by one or more magnetic immersion fields, trajectories of the electrons onto an electron detector of the electron microscope.

9. The method of claim 8, further comprising:
generating, by a device operatively coupled to a processor, an image of a diffraction pattern of the electrons that impinge on the electron detector; and/or
wherein the electron microscope comprises at least one of a scanning electron microscope or a dual beam microscope.

10. The method of claim 9, further comprising, correcting, by the device, deviation of the image of the diffraction pattern.

11. The method of any of claims 8-10, wherein the modifying comprises exciting the one or more magnetic immersion fields by a given value of ampere-turns.

12. The method of claim 10, further comprising:
determining, by the device, the given value of ampere-turns, such that at a given electron landing energy, trajectories of the electrons are directed onto the electron detector.

13. The method of any of claims 8-12, wherein initial trajectories before modification of one or more of the electrons fall outside the area of the electron detector.

14. The method of any of claims 8-13, wherein the one or more magnetic immersion fields are generated by one or more magnetic immersion lens or one or more magnetic coils.

15. A computer program product comprising instructions which, when the program is executed by a computer, cause the computer to carry out the steps of the method of any of claims 8-14.
